# EUROPÄISCHE PATENTANMELDUNG

(11) **EP 0 588 244 A2**
(43) Veröffentlichungstag der Anmeldung: **23.03.1994**
(21) Anmeldenummer: 93114525.4
(22) Anmeldetag: 10.09.1993
(51) Int. Cl.: H05K 3/00, B23Q 11/10

(54) **Verfahren und Vorrichtung zum Bohren von Leiterplatten**

(30) Priorität: 12.09.1992 DE 4230625
(71) Anmelder: WÜRTH ELEKTRONIK GmbH & Co. KG, D-74676 Niedernhall (DE)
(72) Erfinder: Binder, Herbert, D-74635 Kupferzell (DE)
(74) Vertreter: Patentanwälte Ruff, Beier, Schöndorf und Mütschele

(57) **Zusammenfassung**

Beim Bohren von Leiterplatten mit Hilfe von hochtourig arbeitenden Mikrobohrern tritt eine starke Erhitzung der Bohrer auf. Zur Verbesserung der Schnittleistung und zur Verbesserung der Qualität der gebohrten Löcher wird vorgeschlagen, den Bohrer (4) während des Bohrens durch einen direkt auf ihn (4) gerichteten Strahl kalten Kühlmittels in Form eines Gases und/oder einer Flüssigkeit zu kühlen.

## Beschreibung

Die Erfindung betrifft ein Verfahren und eine Vorrichtung zum Bohren von Leiterplatten.

Leiterplatten, die bei vielen Anwendungsfällen aus 1, 2 oder mehreren Lagen bestehen, müssen gebohrt werden, damit eine leitende Verbindung zwischen den einzelnen Lagen hergestellt werden kann. Die Bohrungen werden nach Herstellung durchkontaktiert. Die Leiterplatten enthalten häufig sehr große Zahlen von Bohrungen, die zudem noch auf sehr engem Raum untergebracht sind und sehr kleine Durchmesser aufweisen.

Zum Bohren werden sehr feine Bohrer verwendet, die mit einer sehr hohen Drehzahl arbeiten, beispielsweise im Bereich von mehreren zigtausend Umdrehungen pro Minute. Dabei erhitzen sich die Bohrer auf Temperaturen, bei denen die Schneideigenschaften der Bohrer und die Qualität der Löcher abnimmt.

Der Erfindung liegt die Aufgabe zugrunde, auch bei hohen Anforderungen dafür zu sorgen, daß die Bohrlöcher eine hohe Qualität aufweisen.

Zur Lösung dieser Aufgabe schlägt die Erfindung ein Verfahren mit den Merkmalen des Anspruchs 1 und eine Vorrichtung mit den Merkmalen des Anspruchs 9 vor. Weiterbildungen sind Gegenstand der Unteransprüche.

Erfindungsgemäß wird also der Bohrer in einem bestimmten Bereich gekühlt, nämlich außerhalb der Leiterplatte. Es erfolgt damit keine Beeinträchtigung der Leiterplatte, sondern nur eine Kühlung des Bohrers selbst. Insbesondere kann vorgesehen sein, daß der Kühlmittelstrahl direkt auf den Bohrer gerichtet wird. Als Kühlmittel wird mit Vorteil ein gekühltes Gas verwendet. Ist das Kühlmittel eine Flüssigkeit, dann ist diese mit Vorteil eine solche, die bei Umgebungstemperatur oder bei tieferen Temperaturen rückstandsfrei verdampft. Der Kühlmittelstrahl kann auch aus einem Gemisch aus Flüssigkeit und Gas bestehen.

In Weiterbildung kann vorgesehen sein, daß der Kühlstrahl senkrecht zur Bohrerachse verläuft.

Die Erwärmung des Bohrers erfolgt während des Bohrens selbst. Nach dem Bohren eines Lochs wird der Bohrer zurückgezogen, seitlich versetzt und anschließend zum Bohren eines weiteren Lochs wieder abgesenkt. Die Erfindung schlägt in Weiterbildung nun vor, den Kühlmittelstrahl sowohl während des Bohrens als auch während des Rückzuges des Bohrers und vorzugsweise auch während der Pausen zwischen den Bohrvorgängen aufrechtzuerhalten. Der Bohrer kann also auch während der Zeit, in der er sich nicht erwärmt, weiter gekühlt werden.

Es kann erfindungsgemäß vorgesehen sein, daß zur Verbesserung der Kühlung die Pausen zwischen den Bohrvorgängen vergrößert werden können.

Erfindungsgemäß wird der Gasstrahl mit Vorteil in den Niederhalter des Bohrkopfs eingeblasen.

Erfindungsgemäß kann vorgesehen sein, als Quelle für den Gasstrahl flüssiges Kohlendioxid oder auch flüssigen Stickstoff zu verwenden.

Die von der Erfindung vorgeschlagene Vorrichtung enthält eine Einspritzdüse, die mit einer Kühlmittelquelle verbunden ist und deren Verlängerung den Bohrer bzw. dessen Achse insbesondere rechtwinklig trifft. Der aus der Einspritzdüse austretende Kühlmittelstrahl trifft damit exakt den Bohrer selbst.

Erfindungsgemäß kann zwischen der Kühlmittelquelle, beispielsweise einem Behälter für flüssigen Stickstoff oder flüssiges Kohlendioxid, und der Einspritzdüse eine Dosiereinrichtung vorgesehen sein, die insbesondere dazu dienen kann, die Geschwindigkeit des Ausströmens des Kühlmittels konstant zu halten oder zu regeln. Die Dosiereinrichtung kann ebenfalls eine Kontrolleinrichtung aufweisen, in der beispielsweise bei Stillsetzen des Bohrers auch die Kühlung stillgelegt wird.

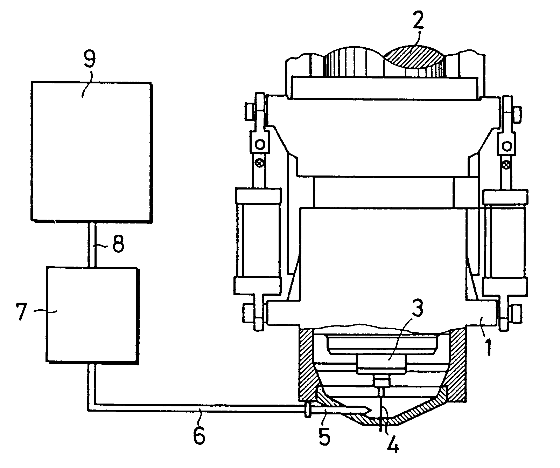

Weitere Merkmale, Einzelheiten und Vorzüge der Erfindung ergeben sich aus der folgenden Beschreibung einer bevorzugten Ausführungsform der Erfindung sowie anhand der Zeichnung.

Hierbei zeigt die einzige Zeichnungsfigur schematisch eine Anordnung eines Niederhalters mit einer Kühlung nach der Erfindung.

Der in der Figur dargestellte Niederhalter 1 ist an sich bekannt und wird daher nicht im einzelnen erläutert. In seinem oberen Bereich weist er eine Spindel 2 auf, die zum Drehantrieb dient. In seinem unteren Bereich ist eine Spannvorrichtung 3 für den Bohrer 4 zu sehen. Der Bohrer ragt an der Unterseite aus dem Niederhalter 1 heraus. Bei dem Bohrer kann es sich um einen Mikrobohrer in dem bei der Bohrung von Platinen üblichen Bereich von etwa 0,1 - 6,5 mm Durchmesser oder um Fräser handeln.

Der Niederhalter 1 weist in diesem Bereich eine Einspritzdüse 5 auf, die etwa radial angeordnet ist. Die Einspritzdüse zielt auf die Bohrerachse 4 und trifft diese unter einem rechten Winkel. Die Einspritzdüse 5 ist über eine schematisch dargestellte Leitung 6 mit einem Dosier- und Kontrollgerät 7 verbunden, das seinerseits über eine weitere Leitung 8 mit einem Behälter 9 verbunden ist. In dem Behälter 9 ist beispielsweise flüssiges Kohlendioxid enthalten, das, kontrolliert durch das Gerät 7, über die Leitung 6 zu der Einspritzdüse 5 fließt. Beim Austreten aus der Einspritzdüse 5 verdampft das flüssige Gas mindestens teilweise und erzeugt einen kalten Kühlmittelstrom, der direkt auf den Bohrer gerichtet ist. Insbesondere bei Verwendung von flüssigem Stickstoff als Kühlmittel kann der Flüssigkeitsstrahl direkt an den Bohrer gelangen. Der Bohrer wird sowohl während des Bohrens selbst, also während des Vorschubs des Bohrers, gekühlt, als auch während der zwischen den einzelnen Bohrvorgängen auftretenden Pausen. Eine Erwärmung des Bohrers tritt nur während des Bohrvorgangs auf, so daß er während der folgenden Pause auch dann abgekühlt werden kann, wenn die Kühlleistung nicht ausreicht, seine Erwärmung während des Bohrvorgangs zu verhindern.

Wenn eine Maschine mehrere Niederhalter, bzw. Spindeln aufweist, so kann erfindungsgemäß vorgesehen sein, daß für jeden Niederhalter, bzw. Spindel eine derartige Einspritzdüse 5 vorgesehen ist.

## Patentansprüche

1. Verfahren zum Bohren von Leiterplatten, bei dem der Bohrer (4) in seinem Bereich kurz vor der Leiterplatte mit Hilfe mindestens eines Strahles eines Kühlmittels aus einem Gas- und/oder einer Flüssigkeit gekühlt wird.

2. Verfahren nach Anspruch 1, bei dem der Kühlmittelstrahl direkt auf den Bohrer (4) gerichtet wird.

3. Verfahren nach Anspruch 1 oder 2, bei dem der Kühlmittelstrahl senkrecht zur Bohrerachse verläuft.

4. Verfahren nach einem der vorhergehenden Ansprüche, bei dem der Kühlmittelstrahl sowohl während des Bohrens als auch während der Pausen zwischen den Bohrvorgängen aufrechterhalten wird.

5. Verfahren nach einem der vorhergehenden Ansprüche, bei dem zur Verbesserung der Kühlung die Pausen zwischen den Bohrvorgängen vergrößert werden.

6. Verfahren nach einem der vorhergehenden Ansprüche, bei dem der Kühlmittelstrahl in den Niederhalter etwa radial eingebracht wird.

7. Verfahren nach einem der vorhergehenden Ansprüche, bei dem als Kühlmittelquelle flüssiges Kohlendioxid verwendet wird.

8. Verfahren nach einem der Ansprüche 1 bis 7, bei dem als Kühlmittelquelle flüssiger Stickstoff verwendet wird.

9. Vorrichtung zum Bohren von Leiterplatten, mit einem Bohrer (4) und einem Niederhalter (1), an dem eine Einspritzdüse (5) angeordnet ist, die mit einer Kühlmittelquelle (9) verbunden ist und deren Verlängerung den Bohrer (4) bzw. dessen Achse trifft.

10. Vorrichtung nach Anspruch 9, bei der die Verlängerung der Einspritzdüse (5) die Bohrerachse rechtwinklig trifft.

11. Vorrichtung nach Anspruch 9 oder 10, bei der die Kühlmittelquelle (9) ein Behälter mit flüssigem Kohlendioxid ist.

12. Vorrichtung nach Anspruch 9 oder 10, bei der die Kühlmittelquelle (9) ein Behälter mit flüssigem Stickstoff ist.

13. Vorrichtung nach einem der Ansprüche 9 bis 12, bei der zwischen der Kühlmittelquelle (9) und der Einspritzdüse (5) eine Dosier- und Kontrolleinrichtung (7) vorgesehen ist.
